(19) Europäisches Patentamt / European Patent Office / Office européen des brevets

(11) **EP 4 354 165 A1**

(12) **EUROPEAN PATENT APPLICATION**
published in accordance with Art. 153(4) EPC

(43) Date of publication:
**17.04.2024  Bulletin 2024/16**

(21) Application number: **22852694.3**

(22) Date of filing: **21.06.2022**

(51) International Patent Classification (IPC):
**G01R 31/392** (2019.01)      **G01R 31/367** (2019.01)
**H01M 10/42** (2006.01)      **H01M 10/48** (2006.01)
**H02J 7/00** (2006.01)

(52) Cooperative Patent Classification (CPC):
**G01R 31/367; G01R 31/392; H01M 10/42;
H01M 10/48; H02J 7/00; H02J 13/00;** Y02E 60/10

(86) International application number:
**PCT/JP2022/024726**

(87) International publication number:
**WO 2023/013268 (09.02.2023 Gazette 2023/06)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority:  **06.08.2021   JP 2021130122**

(71) Applicant: **Toyo System Co., Ltd.
Iwaki-shi, Fukushima 972-8316 (JP)**

(72) Inventors:
• **MUNAKATA Ichiro**
  **Iwaki-shi, Fukushima 972-8316 (JP)**
• **IGARI Shuntaro**
  **Iwaki-shi, Fukushima 972-8316 (JP)**
• **TANNO Satoshi**
  **Iwaki-shi, Fukushima 972-8316 (JP)**
• **SHOJI Hideki**
  **Iwaki-shi, Fukushima 972-8316 (JP)**

(74) Representative: **Schön, Christoph
Dr. Schön, Neymeyr & Partner mbB
Bavariaring 26
80336 München (DE)**

(54) **BATTERY PERFORMANCE EVALUATION DEVICE AND BATTERY PERFORMANCE EVALUATION METHOD**

(57)    Provided is a device and the like that make it possible to improve the accuracy of evaluation of the performance of a secondary battery by taking into account a change in the state of the battery capacity of the secondary battery. A first degree of deterioration is evaluated on the basis of a first initial index value and a first present index value. The first initial index value is a value based on a difference in initial battery capacity $\Delta Q$ ($0 \leftarrow k$) of the target secondary battery between a start time $t = t_1$ and an end time $t = t_2$ of a specified period including a period $[\tau_1, \tau_2]$ during which a current I flows through the target secondary battery. The difference in initial battery capacity $\Delta Q$ ($0 \leftarrow k$) of the target secondary battery is a value determined as an output of a first initial characteristic model by inputting, to the first initial characteristic model, open-circuit voltages $V_{oc2}$ and $V_{oc1}$ of the target secondary battery at the start time and the end time, respectively, of the specified period. The degree of deterioration of the target secondary battery is evaluated from the ratio of a difference in present battery capacity $\Delta Q'$ of the target secondary battery between the start time and the end time of the specified period with respect to the difference in initial battery capacity $\Delta Q$ ($0 \leftarrow k$) of the target secondary battery.

FIG.1

**Description**

Technical Field

The present invention relates to a system and the like that determine the deterioration state of a secondary battery such as a lithium-ion battery.

Background Art

The present inventors have proposed a technical method for determining the deterioration state of a target secondary battery even when no initial measurement result of the characteristic parameters of the secondary battery itself is available (refer to Patent Literature 1). To be specific, based on measurement values ($V$ $(k)$, $I$ $(k)$) of the voltage and the current, respectively, of a secondary battery, the value of the voltage ($V$) at an initial time is calculated as an initial characteristic estimated value ($V$ $(0{\leftarrow}k)$) according to a multivariable function ($G$) that represents an initial characteristic model. The initial characteristic estimated value ($V$ $(0{\leftarrow}k)$) is defined as the evaluation reference of the degree of deterioration of the secondary battery.

Citation List

Patent Literature

Patent Literature 1: Japanese Patent No. 6745554

Summary of Invention

Technical Problem

However, according to the prior art, an initial characteristic model is constructed taking the internal resistance of a secondary battery into account, so that the deterioration state based on a change in the internal resistance of the secondary battery can be evaluated, whereas it may be difficult to evaluate the deterioration state based on a change in the battery capacity of the secondary battery, because the battery capacity of the secondary battery is not taken into account. Consequently, even when the battery capacity of the secondary battery has changed relatively significantly from the initial characteristics thereof, the deterioration degree of the secondary battery may be evaluated improperly as low due to a small amount of change in the internal resistance of the secondary battery from the initial characteristics thereof.
Therefore, an object of the present invention is to provide a device and the like that make it possible to improve the accuracy of evaluation of the performance of a secondary battery by taking into account a change in the state of the battery capacity of the secondary battery.

Solution to Problem

A battery performance evaluation device in accordance with the present invention evaluates that a first degree of deterioration derived from a change in battery capacity of a target secondary battery becomes higher as a difference between a first initial index value and a first present index value becomes larger:

the first initial index value being based on a difference in initial battery capacity of the target secondary battery between a start time and an end time of a specified period, and determined as an output of a first initial characteristic model by inputting, to the first initial characteristic model, at least one of a difference between measurement values of an open-circuit voltage of the target secondary battery at the start time and the end time of the specified period including a period during which a current flows through the target secondary battery, and a difference in present battery capacity of the target secondary battery between the start time and the end time of the specified period; and the first present index value being based on a difference in present battery capacity of the target secondary battery between the start time and the end time of the specified period, and the difference in present battery capacity of the target secondary battery being determined on the basis of a time series of measurement values of current of the target secondary battery in the specified period.

According to the battery performance evaluation device having the above-described configuration, the first degree of deterioration is evaluated on the basis of the first initial index value and the first present index value. The "first initial index value" is a value based on the difference in initial battery capacity (estimated values) of a target secondary battery at the start time and the end time of a specified period including a period during which a current flows through the target secondary battery. The difference in initial battery capacity (estimated value) of a target secondary battery is a value determined as an output of a first initial characteristic model by inputting, to a first initial characteristic model, at least one of the difference between the measurement values of the open-circuit voltage of the target secondary battery at the start time and the end time of the specified period, and the difference in present battery capacity of the target secondary battery at the start time and the end time of the specified period. The "first present index value" is a value based on a difference in present battery capacity of the target secondary battery between the start time and the end time of the specified period. The difference in present battery capacity of the target secondary battery is a value determined on the basis of the time series of the measurement values of the current of the target secondary battery in the specified period. Therefore, based on the first degree of deterioration, the accuracy of evaluating the performance of the target secondary battery derived from a change in battery capacity with respect to the initial characteristics of the target secondary battery is improved.

The battery performance evaluation device having the above-described configuration preferably evaluates that a second degree of deterioration derived from a change in an internal resistance of the target secondary battery becomes higher as a difference between a second initial index value and a second present index value becomes larger,

the second initial index value being based on an initial internal resistance of the target secondary battery, and determined as an output of a second initial characteristic model by inputting, to the second initial characteristic model, a measurement value of at least one of a voltage and a current of the target secondary battery at a specified time, and
the second present index value being based on a present internal resistance of the target secondary battery, and determined on the basis of measurement values of an open-circuit voltage, a voltage, and a current of the target secondary battery.

According to the battery performance evaluation device having the above-described configuration, the second degree of deterioration is evaluated on the basis of a second initial index value and a second present index value. The "second initial index value" is a value based on the initial internal resistance of a target secondary battery. The initial internal resistance of the target secondary battery takes a value determined as an output of a second initial characteristic model by inputting the measurement value of at least one of the voltage and the current of the target secondary battery to the second initial characteristic model. The "second present index value" is a value based on a present internal resistance of the target secondary battery. The present internal resistance of the target secondary battery takes a value determined on the basis of the measurement values of the open-circuit voltage, the voltage, and the current of the target secondary battery. Consequently, based on the second degree of deterioration, the accuracy of evaluating the performance of the target secondary battery derived from a change in the internal resistance with reference to the initial characteristics of the target secondary battery is improved.

Brief Description of Drawings

FIG. 1 is an explanatory diagram related to the configuration of a battery performance evaluation device as an embodiment of the present invention.
FIG. 2 is a block diagram illustrating the functions of the battery performance evaluation device.
FIG. 3 is an explanatory diagram related to the I-V characteristics of a secondary battery.
FIG. 4 is an explanatory diagram related to a battery performance evaluation method as an embodiment of the present invention.
FIG. 5 is an explanatory diagram related to the relationship between open-circuit voltage and battery capacity of a secondary battery.
FIG. 6 is an explanatory diagram related to an example of output of deterioration diagnosis information.

Description of Embodiments

(Configuration of a battery performance evaluation device)

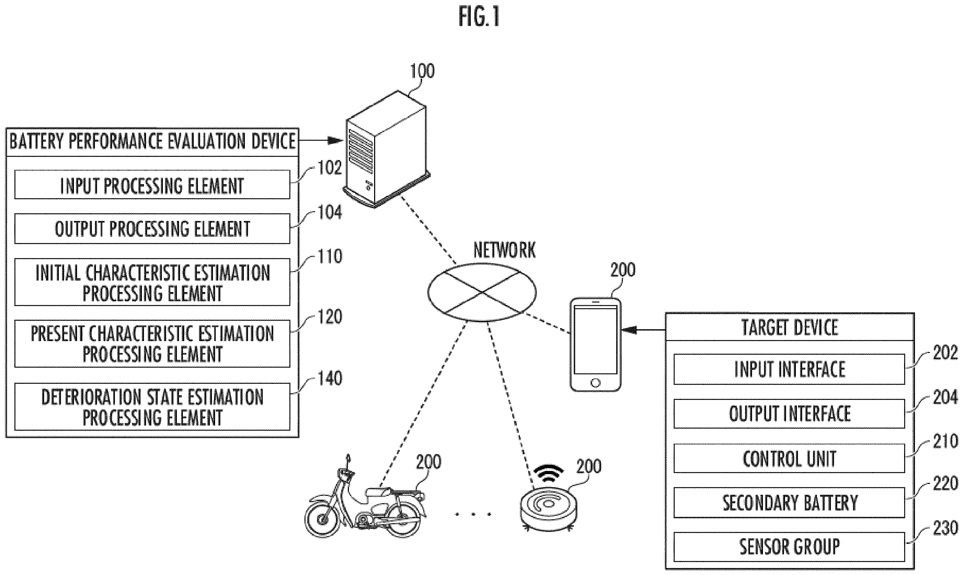

A battery performance evaluation device as an embodiment of the present invention illustrated in FIG. 1 is composed of one or a plurality of servers capable of communicating with a target device 200 through a network. A battery performance evaluation device 100 determines the deterioration state of a target secondary battery 220 installed as a power supply in the target device 200.

The battery performance evaluation device 100 has an input processing element 102, an output processing element 104, an initial characteristics estimation processing element 110, a present characteristic estimation processing element 120, and a deterioration state estimation processing element 140.

The input processing element 102 receives, from the target device 200, the measurement values of a voltage V, a current I, and the like of the target secondary battery 220 installed in the target device 200. The output processing element 104 transmits, to the target device 200, a result of the estimated deterioration state of the target secondary battery 220 or deterioration diagnosis information generated on the basis of the result of the estimated deterioration state.

Each of the initial characteristics estimation processing element 110, the present characteristic estimation processing element 120, and the deterioration state estimation processing element 140 is composed of a common or separate processor (arithmetic processing unit), a memory (storage device), I/O circuits, and the like. Programs (software) as well as various data such as characteristic parameters representing the characteristics of the target secondary battery 220 are stored and held in the memory or a storage device separate therefrom. Each of a plurality of identifiers for identifying the type of the target secondary battery 220 or the target device 200 having the target secondary battery 220 installed therein is associated with each of a plurality of models, and stored and held in the memory. The processor reads a necessary program and data from the memory to carry out arithmetic processing according to the program on the basis of the data, thereby performing tasks assigned to the estimation processing elements 110, 120, and 140.

The target device 200 has an input interface 202, an output interface 204, a control unit 210, the target secondary battery 220, and a sensor group 222. The target device 200 includes all devices that use the target secondary battery 220 as a power supply, such as a personal computer, a cellular phone (smartphone), a household appliance, and a mobile object such as an electric bicycle.

The control unit 210 is composed of a processor (arithmetic processing device), a memory (storage device), I/O circuits, and the like. Various data such as the time series of measurement values of characteristic parameters is stored and held in the memory or a storage device separate therefrom. The control unit 210 operates in response to power supplied from the target secondary battery 220 to control the operation of the target device 200 in an energized state. The operation of the target device 200 includes the operation of an actuator (electric actuator or the like) constituting the target device 200. The processor constituting the control unit 210 reads a necessary program and data from the memory to carry out arithmetic processing according to the program on the basis of the data, thereby performing an assigned task.

The target secondary battery 220 is, for example, a lithium-ion battery, and may be any other secondary battery such as a nickel-cadmium battery. The sensor group 222 measures the values of parameters required for controlling the target device 200, in addition to the characteristic parameters of the target secondary battery 220. The sensor group 222 is composed of, for example, a voltage sensor, a current sensor, and a temperature sensor that output signals based on the voltage, the current, and the temperature, respectively, of the target secondary battery 220.

The battery performance evaluation device 100 may be installed in the target device 200. In this case, a software server (not illustrated) may transmit software for determining deterioration to an arithmetic processing unit constituting the control unit 210 provided in the target device 200, thereby imparting a function as the battery performance evaluation device 100 to the arithmetic processing unit.

(Configuration of each estimation processing element)

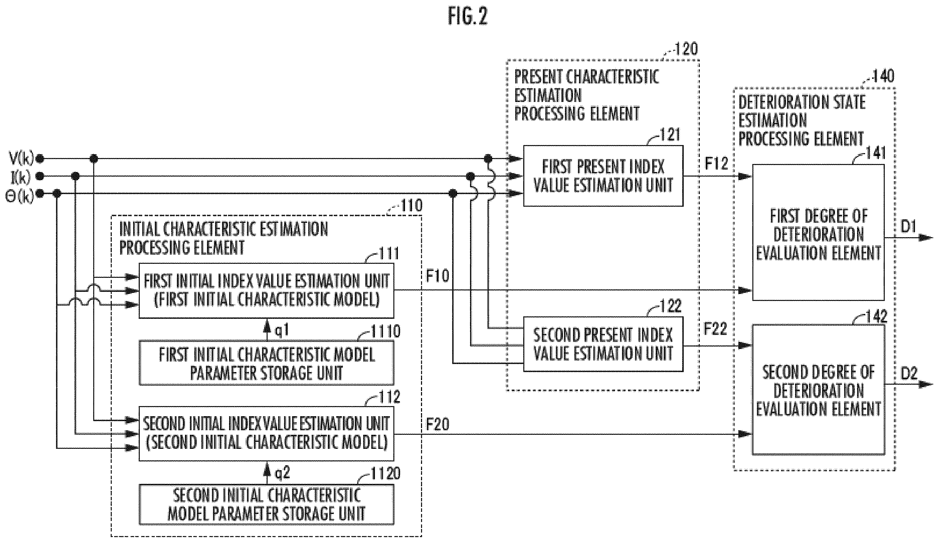

FIG. 2 is a block diagram illustrating the function of each of the estimation processing elements 110, 120, and 140.

The initial characteristics estimation processing element 110 is provided with functions as a first initial characteristic model parameter storage unit 1110 and a first initial index value estimation unit 111, and functions as a second initial characteristic model parameter storage unit 1120 and a second initial index value estimation unit 112. The present characteristic estimation processing element 120 is provided with functions as a first present index value estimation unit 121 and a second present index value estimation unit 122. The deterioration state estimation processing element 140 is provided with functions as a first degree of deterioration evaluation element 141 and a second degree of deterioration evaluation element 142.

The first initial characteristic model parameter storage unit 1110 stores and holds a first initial characteristic model parameter $q_1$ ($p_1$) that represents the initial characteristics of any secondary battery of the same standard or the same type as that of a reference secondary battery. The first initial characteristic model parameter $q_1$ ($p_1$) has a plurality of identifier IDs for identifying the standard or the type of the secondary battery and a plurality of values corresponding to the measurement results of a plurality of first characteristic parameters $p_1$.

In the first initial characteristic model, for each of a plurality of reference secondary batteries having different standards, the relationship among a difference in open-circuit voltage $\Delta V_{oc}$, a temperature $\Theta$, and a difference in battery capacity $\Delta Q$ is approximately represented by a relational expression (110) using, for example, a difference in reference open-circuit voltage $\Delta V_{oc0}$ (specified by the specifications or the standard of a battery) and a reference temperature $\Theta_0$

(e.g., a temperature of 20 to 25°C in the vicinity of room temperature).

$$Q(V_{oc}, \Theta) = Q(V_{oc0}, \Theta_0) + (\partial Q / \partial V_{oc})(V_{oc} - V_{oc0}) + (\partial Q / \partial \Theta)(\Theta - \Theta_0)$$

$$.. (110)$$

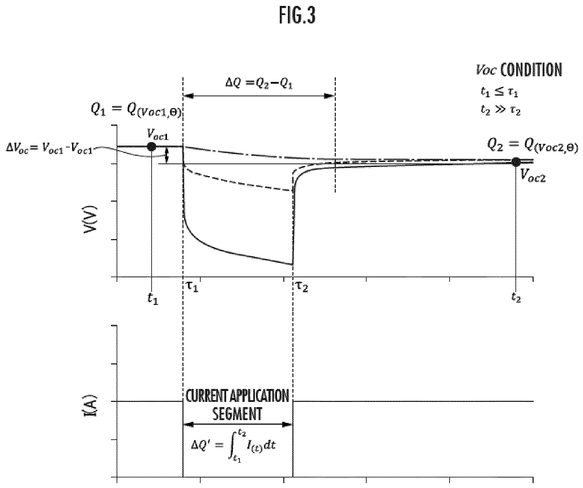

FIG. 3 illustrates, with the dashed line, a current I vs voltage V characteristic curve of a secondary battery of the initial characteristics at the time of returning to a state in which no current is flowing after a period during which current flows $[\tau_1, \tau_2]$ from the state in which no current flows. The current I vs voltage V characteristic curve of a secondary battery that has deteriorated to a certain extent is illustrated with the solid line. The chain line indicates changes in the calculation of the open-circuit voltage $V_{oc}$ of the secondary battery of the initial characteristics. From FIG. 3, it is seen that the amount of change in the voltage V of the secondary battery during the period in which current flows tends to increase as the deterioration of the secondary battery progresses. In addition, the amount of change in the open-circuit voltage $V_{oc}$ also increases. In FIG. 3, $t_1$ and $t_2$ denote the open-circuit voltage measurement time, and are defined by the time elapsed until the diffusion phenomenon converges after the application of a current.

For example, the difference $\Delta V_{oc}$ in the open-circuit voltage $V_{oc}$ of the reference secondary battery between start time $t = t_1$ and end time $t = t_2$ in a specified period $[t_1, t_2]$ illustrated in FIG. 3 is estimated. The temperature average value of the reference secondary battery in the specified period or the temperature at an arbitrary time included in the specified period is estimated as the temperature $\Theta$. As illustrated in FIG. 3, the difference $\Delta Q$ in battery capacity Q between start time $t = \tau_1$ and end time $t = \tau_2$ in a period during which current flows $[\tau_1, \tau_2]$ in the specified period is estimated as the difference in battery capacity $\Delta Q$ of the reference secondary battery. In the relational expression (110), the term related to the temperature $\Theta$ (the third term on the right side) may be omitted.

The first initial characteristic model may be expressed by, for example, one of the relational expressions (111) and (112), using a partial differential coefficient $(\partial^m Q / \partial p_1^m)$ of an m-th order $(2 \leq m)$ instead of or in addition to a first-order partial differential coefficient $(\partial Q / \partial p_1)$ $(p_1 = V_{oc}, \Theta)$.

$$Q(V_{oc}, \Theta) = Q(V_{oc0}, \Theta_0) + (\partial Q / \partial V_{oc})(V_{oc} - V_{oc0}) + \cdots + (\partial^m Q / \partial V_{oc}^m)(V_{oc} -$$
$$V_{oc0})^m + (\partial Q / \partial \Theta)(\Theta - \Theta_0) + \cdots + (\partial^m Q / \partial \Theta^m)(\Theta - \Theta_0)^m \cdots (111)$$

$$Q(V_{oc}, \Theta) = Q(V_{oc0}, \Theta_0) + (\partial^2 Q / \partial V_{oc}\partial \Theta)(V_{oc} - V_{oc0})(\Theta - \Theta_0) \cdots (112)$$

The first initial characteristic model may be represented by a relational expression obtained by omitting the terms related to the temperature $\Theta$ in the above relational expressions. The first initial characteristic model may be defined not as a relational expression but as a model such as a machine learning model or a deep learning model that has input-output characteristics equivalent to the relational expression.

The difference in open-circuit voltage $\Delta V_{oc}$, the difference in battery capacity $\Delta Q$, and the temperature $\Theta$ of the reference secondary battery in the initial characteristics are measured, and the first-order partial differential coefficient $(\partial Q / \partial p_1)$ $(p_1 = V_{oc}, \Theta)$ is estimated on the basis of the various measurement results $(\Delta V_{oc}, \Delta Q, $ and $\Theta)$. A time-integrated value or cumulative value of the current $I(t)$ of the target secondary battery in the specified period $[t_1, t_2]$ is estimated as the difference in battery capacity $\Delta Q'$ of the target secondary battery.

[Math. 1]

$$\Delta Q' = \int_{t_1}^{t_2} I_{(t)}dt \cdots (113)$$

Then, the partial differential coefficient $(\partial Q / \partial p_1)$ is stored and held in the first initial characteristic model parameter storage unit 1110 as a first initial characteristic model parameter $q_1(p_1)$. Based on the estimation result of a discrete partial differential coefficient $(\partial Q / \partial p_1)$, the partial differential coefficient $(\partial Q / \partial p_1)$ may be approximately expressed by a continuous function of the main variables $V_{oc}$, Q, and $\Theta$, and the continuous function for determining the first initial characteristic model parameter $q_1(p_1)$ may be stored and held in the first initial characteristic model parameter storage unit 1110.

The second initial characteristic model parameter storage unit 1120 stores and holds a second initial characteristic model parameter $q_2$ ($p_2$) representing the initial characteristics of any secondary battery of the same standard or the same type as that of the reference secondary battery. The second initial characteristic model parameter $q_2$ ($p_2$) has a plurality of identifiers IDs for identifying the standard or the type of a secondary battery and a plurality of values corresponding to the measurement results of a plurality of second characteristic parameters $p_2$.

In the second initial characteristic model, for each of the plurality of reference secondary batteries having different standards, the relationship among the internal resistance r, the voltage V, the current I, and the temperature $\Theta$ is approximately represented by a relational expression (120) using, for example, a reference voltage $V_0$ and a reference current $I_0$ (specified by the specifications or the standard of a battery), and the reference temperature $\Theta_0$ (e.g., a temperature of 20 to 25°C in the vicinity of room temperature).

$$r (V, I, \Theta) = r (V_0, I_0, \Theta_0) + ( \partial r / \partial V) (V - V_0) + ( \partial r / \partial I) (I - I_0) + ( \partial r / \partial \Theta) (\Theta - \Theta_0) .. (120)$$

For example, the voltage V, the current I, and the temperature $\Theta$ of the reference secondary battery at an arbitrary time of the specified period [$t_1$, $t_2$] illustrated in FIG. 3 are measured. The term related to the temperature $\Theta$ (the fourth term on the right side) may be omitted in the relational expression (221).

The second initial characteristic model may be expressed by, for example, one of the relational expressions (121) and (122), using a partial differential coefficient ($\partial^m r / \partial p_2^m$) of the m-th order ($2 \leq m$) instead of or in addition to a first-order partial differential coefficient ($\partial r / \partial p_2$) ($p_2 = V, I, \Theta$).

$$r (V, I, \Theta) = r (V_0, I_0, \Theta_0) + (\partial r / \partial V) (V - V_0) + \cdots + (\partial^m r / \partial V^m) (V - V_0)^m + (\partial r / \partial I) (I - I_0) + \cdots + (\partial^m r / \partial I^m) (I - I_0)^m + (\partial r / \partial \Theta) (\Theta - \Theta_0) \cdots (121)$$

$$r (V, I, \Theta) = r (V_0, I_0, \Theta_0) + ( \partial^2 r / \partial V^2) (V - V_0)^2 + ( \partial^2 r / \partial I^2) (I - I_0)^2 + ( \partial^2 r / \partial V \partial I) (V - V_0) (I - I_0) + ( \partial^2 r / \partial \Theta^2) (\Theta - \Theta_0)^2 \cdots (122)$$

The second initial characteristic model may be represented by a relational expression obtained by omitting the terms related to the temperature $\Theta$ in the above relational expressions. The second initial characteristic model may be defined not as a relational expression but as a model such as a machine learning model or a deep learning model that has input-output characteristics equivalent to the relational expression.

The open-circuit voltage $V_0$, the voltage V, the current I, and the temperature $\Theta$ of the reference secondary battery in the initial characteristics are measured, and the first-order partial differential coefficient ($\partial r / \partial p_2$) ($p_2 = V, I, \Theta$) is estimated on the basis of the various measurement results ($V_0$, V, I, and $\Theta$). The internal resistance r of the reference secondary battery is estimated according to a relational expression $r = (V - V_0) / I$. Then, the partial differential coefficient ($\partial Q / \partial p_1$) is stored and held in the second initial characteristic model parameter storage unit 1120 as a second initial characteristic model parameter $q_2$ ($p_2$). Based on the estimation result of a discrete partial differential coefficient ($\partial r / \partial p_2$), the partial differential coefficient ($\partial r / \partial p_2$) may be approximately expressed by a continuous function of the main variables V, I, and O, and the continuous function for determining the second initial characteristic model parameter $q_2$ ($p_2$) may be stored and held in the second initial characteristic model parameter storage unit 1120.

(Battery performance evaluation method)

A description will be given of a method for evaluating the performance of the target secondary battery 220 carried out by the battery performance evaluation device having the above-described configuration.

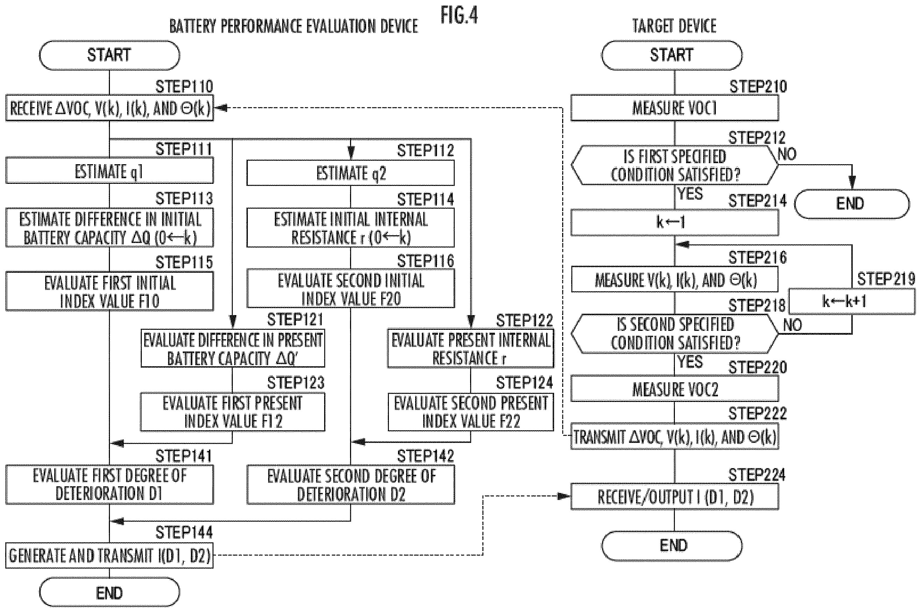

An open-circuit voltage $V_{oc1}$ of the target secondary battery 220 at a start time $t = t_1$ of a specified period is measured using a voltage sensor constituting the sensor group 222 in a state in which no current I or only a negligible minute current is flowing through the target secondary battery 220 (e.g., when the target device 200 is in a power OFF state or a sleep state) (STEP210 of FIG. 4). At this time, the temperature $\Theta$ ($t_1$) of the target secondary battery 220 may be measured. A minimum minute electric power required for measuring the open-circuit voltage $V_{oc1}$ may be supplied to the control unit 210 from the target secondary battery 220 or a capacitor separate from the target secondary battery.

The control unit 210 in an energized state determines whether a first specified condition is satisfied (STEP212 of FIG. 4). The "first specified condition" includes the target device 200 having been switched from a power OFF mode or a sleep mode to a power ON mode or a startup mode through the input interface 202. The first specified condition may include, for example, the reception of a request for evaluating the battery performance of the target secondary battery 220 through the input interface 202 in the target device 200, the startup of predetermined application software in the target device 200, and the indication of a first change mode (a rapid drop or discontinuous change) in a measurement value V (k) of the voltage V of the target secondary battery 220 measured by the sensor group 222.

If it is determined that the first specified condition is not satisfied (NO in STEP212 of FIG. 4), then a series of processing ends. On the other hand, if it is determined that the first specified condition is satisfied (YES in STEP212 of FIG. 4), then an index k is set to "1" (STEP214 of FIG. 4), and then based on an output signal of the sensor group 222, the measurement values of the voltage V, the current I, and the temperature $\Theta$ (V (k), I (k), and $\Theta$ (k)) of the target secondary battery 220 are acquired (STEP216 of FIG. 4). "k" is an index representing a discrete time based on a sampling period, and is an index representing a time in a period $[\tau_1, \tau_2]$ during which a current flows through the target secondary battery 220 illustrated in FIG. 3.

Subsequently, the control unit 210 determines whether a second specified condition is satisfied (STEP218 of FIG. 4). The "second specified condition" includes the current I flowing through the target secondary battery 220 having become zero or minute again. The second specified condition may include, for example, a time t = $\tau_2$ having been reached at which a predetermined time has elapsed from a time t = $\tau_1$ at which the first specified condition was last determined to have been satisfied, the cumulative value of the data, which shows the measurement results of the characteristic parameter p (k), from a first time having reached a threshold value, the measurement value V (k) of the voltage V of the target secondary battery 220 measured by the sensor group 222 having shown a second change mode (a rapid increase or a discontinuous change).

If it is determined that the second specified condition is not satisfied (NO in STEP218 of FIG. 4), then the index k is incremented by "1" (STEP219 of FIG. 4), and then based on an output signal of the sensor group 222, the measurement values of the voltage V, the current I, and the temperature $\Theta$ (V (k), I (k), and $\Theta$ (k)) of the target secondary battery 220 are acquired (STEP216 of FIG. 4). The measurement values are cumulatively or sequentially stored and held in a memory.

If it is determined that the second specified condition is satisfied (YES in STEP218 of FIG. 4), then an open-circuit voltage $V_{oc2}$ of the target secondary battery 220 at an end time t = $t_2$ of the specified period is measured using the voltage sensor constituting the sensor group 222 (STEP220 of FIG. 4). At this time, the temperature $\Theta$ ($t_2$) of the target secondary battery 220 may be measured.

The difference in open-circuit voltage $\Delta V_{oc} = V_{oc2} - V_{oc1}$ of the target secondary battery 220 and the time series of the measurement values of the voltage V, the current I, and the temperature $\Theta$ (V (k), I (k), and $\Theta$ (k)) are transmitted to the battery performance evaluation device 100 from the target device 200 by a transmission device constituting the output interface 204 (STEP222 of FIG. 4). At an appropriate timing, an identifier ID for identifying the standard or the type of the target secondary battery 220 is also transmitted to the battery performance evaluation device 100 from the target device 200.

The difference in open-circuit voltage $\Delta V_{oc}$ (or the open-circuit voltages $V_{oc1}$ and $V_{oc2}$) of the target secondary battery 220 and the measurement values of the voltage V, the current I, and the temperature $\Theta$ (V (k), I (k), and $\Theta$ (k)) may be sequentially transmitted to the battery performance evaluation device 100 from the target device 200 upon acquisition of these open-circuit voltage difference and the measurement values.

The battery performance evaluation device 100 receives, through the input processing element 102, the difference in open-circuit voltage $\Delta V_{oc}$ (or the open-circuit voltages $V_{oc1}$ and $V_{oc2}$) of the target secondary battery 220 and the time series of the measurement values of the voltage V, the current I, and the temperature $\Theta$ (V (k), I (k), and $\Theta$ (k)) (STEP 110 of FIG. 4).

The first initial index value estimation unit 111 reads, from the first initial characteristic model parameter storage unit 1110, the identifier ID of the target secondary battery 220 and the first initial characteristic model parameter $q_1$ ($p_1$) corresponding to the difference in open-circuit voltage $\Delta V_{oc}$, the difference in present battery capacity $\Delta Q$ and temperature $\Theta$ (= $\Theta$ ($t_1$), O ($t_2$) or $\Theta$ (k), or the average value of these) (STEP111 of FIG. 4). The first initial characteristic model parameter $q_1$ is the partial differential coefficient ($\partial Q / \partial p_1$) in the above-described relational expression (110).

The first initial index value estimation unit 111 estimates an initial battery capacity Q (0 <— k) according to the relational expression (110) on the basis of the first initial characteristic model parameter $q_1$ ($p_1$), the difference in open-circuit voltage $\Delta V_{oc}$, and the temperature $\Theta$ (STEP 113 of FIG. 4).

The first initial index value estimation unit 111 evaluates or estimates a first initial index value $F_{10}$ according to an increasing function (e.g., increasing functions of various forms such as a linear expression f = x or f = $\alpha_0 + \alpha_1 x$, an n-th polynomial f = $\alpha_0 + \alpha_1 x + .. + \alpha_n x^n$, an exponential function f = exp ($\alpha x$) or a logarithmic function f = log ($\alpha x$), or a combination of these) having the difference in initial battery capacity $\Delta Q$ (0←k) as the main variable x (STEP115 of FIG. 4).

The first present index value estimation unit 121 estimates a difference in present battery capacity $\Delta Q'$ as a time integral value or a cumulative value in the period $[\tau_1, \tau_2]$ of the current I (k) of the target secondary battery 220 (STEP121 of FIG. 4).

The first present index value estimation unit 121 evaluates or estimates a first present index value $F_{12}$ according to an increasing function (e.g., increasing functions of various forms such as a linear expression $f = x$ or $f = \alpha_0 + \alpha_1 x$, an n-th polynomial $f = \alpha_0 + \alpha_1 x + .. + \alpha_n x^n$, an exponential function $f = \exp (\alpha x)$ or a logarithmic function $f = \log (\alpha x)$, or a combination of these) having the difference in present battery capacity $\Delta Q'$ as the main variable x (STEP 123 of FIG. 4).

The first degree of deterioration evaluation element 141 evaluates or estimates a first degree of deterioration $D_1$ according to an increasing function (e.g., increasing functions of various forms such as a linear expression $g = x$ or $g = \beta_0 + \beta_1 x$, an n-th polynomial $g = \beta_0 + \beta_1 x + .. + \beta_n x^n$, an exponential function $g = \exp (\beta x)$ or a logarithmic function $g = \log (\beta x)$, or a combination of these) having a difference $\Delta F_1$ or a ratio $F_{12}/F_{10}$ of the first initial index value $F_{10}$ and the first present index value $F_{12}$ as the main variable x (STEP 141 of FIG. 4).

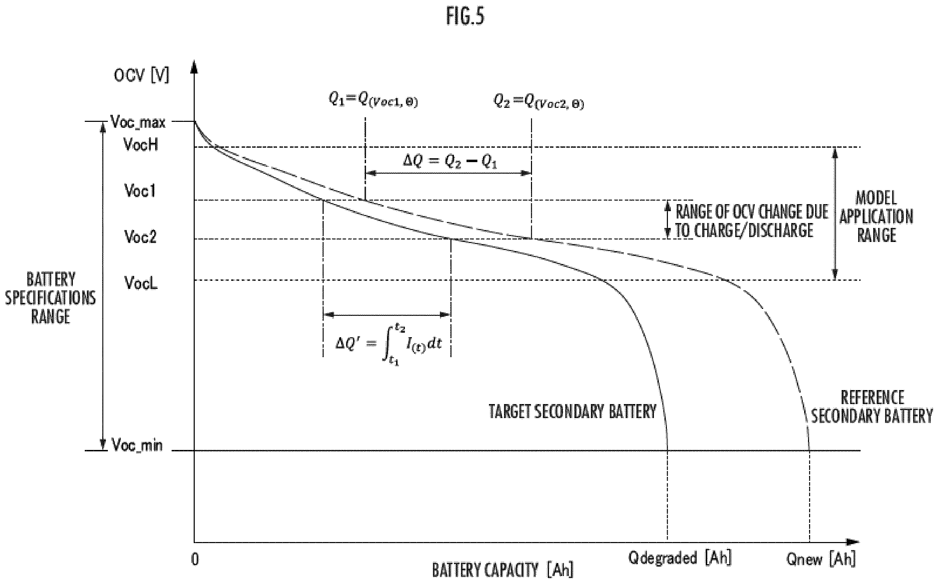

FIG. 5 illustrates a dashed-line curve showing the relationship between the battery capacity Q and the open-circuit voltage $V_{oc}$ of the secondary battery in the initial characteristics, and a solid-line curve showing the relationship between the battery capacity Q and the open-circuit voltage $V_{oc}$ of the secondary battery deteriorated to a certain extent. From FIG. 5, it is seen that the difference in battery capacity $\Delta Q = Q_2 - Q_1$ with respect to a difference in open-circuit voltage $\Delta V = V_{oc2} - V_{oc1}$ tends to decrease as the deterioration of the secondary battery progresses.

The second initial index value estimation unit 112 reads, from the second initial characteristic model parameter storage unit 1120, the identifier ID of the target secondary battery 220 and the second initial characteristic model parameter $q_2 (p_2)$ corresponding to the voltage V, the current I, and the temperature $\Theta$ (values at $t = \tau_1$ or $t = \tau_2$ or average values of V (k), I (k), and $\Theta$ (k)) (STEP112 of FIG. 4). The second initial characteristic model parameter $q_2$ is the partial differential coefficient $(\partial r / \partial p_2)$ in the above-described relational expression (120).

The second initial index value estimation unit 112 estimates an initial internal resistance r $(0 \leftarrow k)$ according to the relational expression (120) on the basis of the second initial characteristic model parameter $q_2 (p_2)$, the voltage V, the current I, and the temperature $\Theta$ (STEP 114 of FIG. 4).

The second initial index value estimation unit 112 evaluates or estimates a second initial index value $F_{20}$ according to an increasing function (e.g., increasing functions of various forms such as a linear expression $f = x$ or $f = \alpha_0 + \alpha_1 x$, an n-th polynomial $f = \alpha_0 + \alpha_1 x + ..+ \alpha_n x^n$, an exponential function $f = \exp (\alpha x)$ or a logarithmic function $f = \log (\alpha x)$, or a combination of these) having the initial internal resistance $(0 \leftarrow k)$ as the main variable x (STEP116 of FIG. 4).

The second present index value estimation unit 122 estimates the present internal resistance r according to a relational expression $r = (V - V_{oc}) / I$ on the basis of the open-circuit voltage $V_{oc}$ ($V_{oc1}$ or $V_{oc2}$, or an average value of these), the voltage V, and the current I of the target secondary battery 220 (STEP 122 of FIG. 4).

The second present index value estimation unit 122 evaluates or estimates a second present index value $F_{22}$ according to an increasing function (e.g., increasing functions of various forms such as a linear expression $f = x$ or $f = \alpha_0 + \alpha_1 x$, an n-th polynomial $f = \alpha_0 + \alpha_1 x + .. + \alpha_n x^n$, an exponential function $f = \exp (\alpha x)$ or a logarithmic function $f = \log (\alpha x)$, or a combination thereof) having the present internal resistance r as the main variable x (STEP 124 of FIG. 4).

The second degree of deterioration evaluation element 142 evaluates or estimates a second degree of deterioration $D_2$ according to an increasing function (e.g., increasing functions of various forms such as a linear expression $g = x$ or $g = \beta_0 + \beta_1 x$, an n-th polynomial $g = \beta_0 + \beta_1 x + .. + \beta_n x^n$, an exponential function $g = \exp (\beta x)$ or a logarithmic function $g = \log (\beta x)$, or a combination of these) having a difference $\Delta F_2$ or a ratio $F_{22}/F_{20}$ of the second initial index value $F_{20}$ and the second present index value $F_{22}$ as the main variable x (STEP142 of FIG. 4).

Deterioration diagnosis information I $(D_1, D_2)$ is generated by the deterioration state estimation processing element 140 on the basis of the first degree of deterioration $D_1$ and the second degree of deterioration $D_2$, and transmitted from the battery performance evaluation device 100 to the target device 200 (STEP144 of FIG. 4). The deterioration diagnosis information may include the degrees of deterioration of the target secondary battery 220 estimated according to a table, an algorithm, or a model established in advance according to the combinations of the first degree of deterioration $D_1$ and the second degree of deterioration $D_2$.

The first degree of deterioration $D_1$ and the second degree of deterioration $D_2$ may be combined by the deterioration state estimation processing element 140 to evaluate a combined degree of deterioration D. The combined degree of deterioration D is evaluated according to, for example, a relational expression $D = C_1 D_1 + C_2 D_2$, using weighting coefficients $C_1$ and $C_2 (= 1 - C_1)$. If the time-series variance of the current measurement value I (k) of the target secondary battery 220 is below a threshold value, then the first degree of deterioration $D_1$ may be weighted (the first weighting coefficient $C_1$ is set to be larger than the second weighting coefficient $C_2$ and the difference therebetween is increased) to determine the combined degree of deterioration D. If the time-series variance of the current measurement value I (k) of the target secondary battery 220 in the specified period is equal to or more than the threshold value, then the second degree of deterioration $D_2$ may be weighted (the first weighting coefficient $C_1$ is set to be smaller than the second weighting coefficient $C_2$ and the difference therebetween is increased) to determine the combined degree of deterioration D.

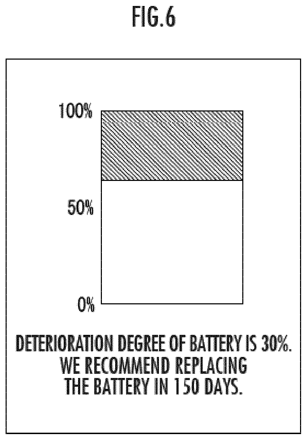

In the target device 200, the deterioration diagnosis information I $(D_1, D_2)$ is received by a receiving device constituting the input interface 202, and output to and displayed on a display device constituting the output interface 204 (STEP224 of FIG. 4). Thus, as illustrated in, for example, FIG. 6, the display device displays the graph showing the first degree of deterioration $D_1$ and the second degree of deterioration $D_2$ of the target secondary battery 220 and also a message related to measures to be taken according to the first degree of deterioration $D_1$ and the second degree of deterioration $D_2$, such as "Deterioration degree of battery is 30%. We recommend replacing the battery in 150 days."

(Effects)

According to the battery performance evaluation device and the battery performance evaluation method of the present invention, the first degree of deterioration $D_1$ is evaluated on the basis of the first initial index value $F_{10}$ and the first present index value $F_{12}$ (refer to STEP115, STEP123 $\rightarrow$ STEP141 of FIG. 4). The "first initial index value $F_{10}$" is a value based on the difference in initial battery capacity $\Delta Q$ ($0 \leftarrow k$) of the target secondary battery 220 between the start time $t = t_1$ and the end time $t = t_2$ of the specified period including the period $[\tau_1, \tau_2]$ during which the current I flows through the target secondary battery 220 (refer to STEP113 $\rightarrow$ STEP115 of FIG. 4). The difference in initial battery capacity $\Delta Q$ ($0 \leftarrow k$) of the target secondary battery 220 is a value determined as an output of the first initial characteristic model by inputting, to the first initial characteristic model, the open-circuit voltages $V_{oc2}$ and $V_{oc1}$ of the target secondary battery 220 at each of the start time $t = t_1$ and the end time $t = t_2$ of the specified period (refer to STEP111 $\rightarrow$ STEP113 of FIG. 4). The "first present index value $F_{12}$" is a value based on the difference in present battery capacity $\Delta Q'$ of the target secondary battery 220 between the start time $t = \tau_1$ and the end time $t = \tau_2$ of the application of voltage in the specified period (refer to STEP121 $\rightarrow$ STEP123 of FIG. 4). The present battery capacity difference of the target secondary battery 220 (refer to the relational expression (113)) is a value determined on the basis of the time series I (k) of the measurement values of the current I of the target secondary battery 220 in the specified period. Thus, based on the first degree of deterioration $D_1$, the accuracy of evaluating the performance of the target secondary battery 220, which is derived from a change in the battery capacity Q with respect to the initial characteristics of the target secondary battery 220, is improved.

Further, the second degree of deterioration $D_2$ is evaluated on the basis of the second initial index value $F_{20}$ and the second present index value $F_{22}$ (refer to STEP116, STEP124 $\rightarrow$ STEP142 of FIG. 4). The "second initial index value $F_{20}$" is a value based on the initial internal resistance r ($0 \leftarrow k$) of the target secondary battery 220 (refer to STEP114 $\rightarrow$ STEP116 of FIG. 4). The initial internal resistance r ($0 \leftarrow k$) of the target secondary battery 220 is a value determined as an output of the second initial characteristic model by inputting, to the second initial characteristic model, the measurement values of the voltage V and the current I of the target secondary battery 220 (refer to STEP112 $\rightarrow$ STEP114 of FIG. 4). The "second present index value $F_{22}$" is a value based on the present internal resistance r of the target secondary battery 220. The present internal resistance r of the target secondary battery 220 is a value determined on the basis of the measurement values of the open-circuit voltage $V_{oc}$, the voltage V, and the current I of the target secondary battery 220 (refer to STEP122 $\rightarrow$ STEP124 of FIG. 4). Thus, based on the second degree of deterioration $D_2$, the accuracy of evaluating the performance of the target secondary battery 220, which is derived from a change in the internal resistance r with respect to the initial characteristics of the target secondary battery 220, is improved.

(Another embodiment of the present invention)

In the above-described embodiment, the first degree of deterioration $D_1$ and the second degree of deterioration $D_2$ were evaluated, but only the first degree of deterioration $D_1$ may be evaluated in another embodiment.
In the above-described embodiment, the first initial characteristic model was defined according to the relational expression that takes into account both the difference in open-circuit voltage $\Delta V_{oc}$ and the temperature $\Theta$ of the secondary battery (refer to the relational expression (110)), and the difference in initial battery capacity $\Delta Q$ ($0 \leftarrow k$) was output from the first initial characteristic model by inputting both the difference in open-circuit voltage $\Delta V_{oc}$ and the temperature $\Theta$ to the first initial characteristic model. However, as another embodiment, the first initial characteristic model may be defined according to a relational expression that takes into account only one of the difference in open-circuit voltage $\Delta V_{oc}$ and the temperature $\Theta$ and the difference in initial battery capacity $\Delta Q$ ($0 \leftarrow k$) may be output from the first initial characteristic model by inputting only one of the difference in open-circuit voltage $\Delta V_{oc}$ and the temperature $\Theta$ to the first initial characteristic model.
In the above-described embodiment, the second initial characteristic model was defined according to the relational expression that takes into account both the voltage V and the current I of the secondary battery (refer to the relational expression (120)), and the initial internal resistance r ($0 \leftarrow k$) was output from the second initial characteristic model by inputting both the voltage V and the current I to the second initial characteristic model. However, as another embodiment, the second initial characteristic model may be defined according to a relational expression that takes into account only one of the voltage V and the current I, and the initial internal resistance r ($0 \leftarrow k$) may be output from the second initial characteristic model by inputting only one of the voltage V and the current I to the second initial characteristic model.

Description of Reference Numerals

100 .. battery performance evaluation device; 102 .. input processing element; 104 .. output processing element; 110 .. initial characteristic estimation processing element; 111 .. first initial index value estimation unit; 112 .. second initial index value estimation unit; 1110 .. first initial characteristic model parameter storage unit; 1120 .. second initial characteristic model parameter storage unit; 120 .. present characteristic estimation processing element; 121 .. first present index value estimation unit; 122 .. second present index value estimation unit; 140 .. deterioration state estimation processing element; 141 .. first degree of deterioration evaluation element; 142 .. second degree of deterioration evaluation element; 200 .. target device; 202 .. input interface; 204 .. output interface; 210 .. control unit; 220 .. target secondary battery; and 222 .. sensor group.

**Claims**

1.  A battery performance evaluation device evaluating that a first degree of deterioration derived from a change in battery capacity of a target secondary battery becomes higher as a ratio between a first initial index value and a first present index value becomes smaller:

    the first initial index value being based on a difference in initial battery capacity of the target secondary battery between a start time and an end time of a specified period, and determined as an output of a first initial characteristic model by inputting, to the first initial characteristic model, at least one of a difference between a measurement value of an open-circuit voltage of the target secondary battery at the start time and a measurement value thereof at the end time of the specified period including a period during which a current flows through the target secondary battery, and a difference in present battery capacity of the target secondary battery between the start time and the end time of the specified period; and
    the first present index value being based on a difference in present battery capacity of the target secondary battery between the start time and the end time of the specified period, and the difference in present battery capacity of the target secondary battery being determined on the basis of a time series of measurement values of current of the target secondary battery in the specified period.

2.  The battery performance evaluation device according to claim 1,
    wherein a value of a parameter of the first initial characteristic model is corrected on the basis of a measurement value of the temperature of the target secondary battery in the specified period.

3.  The battery performance evaluation device according to claim 1 or 2 evaluating that a second degree of deterioration derived from a change in internal resistance of the target secondary battery becomes higher as a ratio between a second initial index value and a second present index value becomes larger:

    the second initial index value being based on an initial internal resistance of the target secondary battery determined as an output of a second initial characteristic model by inputting, to the second initial characteristic model, a measurement value of at least one of a voltage and a current of the target secondary battery at a specified time; and
    the second present index value being based on a present internal resistance of the target secondary battery determined on the basis of measurement values of an open-circuit voltage, a voltage, and a current of the target secondary battery.

4.  The battery performance evaluation device according to claim 3,
    wherein a value of a parameter of the second initial characteristic model is corrected on the basis of a measurement value of a temperature of the target secondary battery at the specified time.

5.  The battery performance evaluation device according to claim 3 or 4,
    wherein a combined degree of deterioration, which combines the first degree of deterioration and the second degree of deterioration are combined, is determined.

6.  The battery performance evaluation device according to claim 5,
    wherein the combined degree of deterioration is determined by weighting the first degree of deterioration in the case where variance in the time series of the measurement values of a current of the target secondary battery in the specified period is below a threshold value, and the combined degree of deterioration is determined by weighting the second degree of deterioration in the case where variance in the time series of the measurement values of a current of the target secondary battery in the specified period is equal to or more than the threshold value.

7. The battery performance evaluation device according to any one of claims 1 to 6, including:

an input processing element that receives, from a target device having the target secondary battery installed therein, a measurement result required for performing arithmetic processing of an initial characteristic estimation processing element and a present characteristic estimation processing element; and
an output processing element that transmits, to the target device, deterioration diagnosis information based on an evaluation result of the degree of deterioration of the target secondary battery provided by a deterioration state estimation processing element.

8. A software server imparting a function as the battery performance evaluation device described in any one of claims 1 to7 to an arithmetic processing device by transmitting software for determining deterioration to the arithmetic processing device provided in the target device with the target secondary battery installed therein.

9. A battery performance evaluation method, comprising:

an initial characteristic estimation step of determining a first initial index value based on an initial battery capacity of a target secondary battery as an output of a first initial characteristic model by inputting, to the first initial characteristic model, a measurement value of an open-circuit voltage of the target secondary battery at each of a start time and an end time of a specified period, and a time series of measurement values of a current of the target secondary battery in the specified period;
a present characteristic estimation step of determining a first present index value based on a present battery capacity of the target secondary battery on the basis of a measurement value of an open-circuit voltage of the target secondary battery at each of a start time and an end time of the specified period, and a time series of measurement values of the current of the target secondary battery in the specified period; and
a degree of deterioration evaluation step of evaluating that a first degree of deterioration derived from a change in battery capacity of the target secondary battery becomes higher as a ratio between the first initial index value determined by the initial characteristic estimation step and the first present index value determined by the present characteristic estimation step becomes smaller.

**Amended claims in accordance with Rule 137(2) EPC.**

1. (Amended) A battery performance evaluation device comprising:

an input processing element that receives measurement values of a plurality of characteristic parameters of a target secondary battery from a target device having the target secondary battery installed therein;
a present characteristic estimation processing element;
an initial characteristic estimation processing element; and
a deterioration state estimation processing element,
wherein the present characteristic estimation processing element estimates a first present index value according to an increasing function having, as a main variable, a difference in present battery capacity between a start time and an end time of a specified period calculated from a time integral value or a cumulative value of a current of the target secondary battery on the basis of a time series of measurement values of current of the target secondary battery as the measurement values of the characteristic parameters received by the input processing element, in the specified period including a period during which a current flows through the target secondary battery,
the initial characteristic estimation processing element estimates a first initial index value according to an increasing function having, as a main variable, a difference in initial battery capacity of the target secondary battery between a start time and an end time of the specified period, the difference in initial battery capacity of the target secondary battery being determined as an output of a first initial characteristic model by inputting, to the first initial characteristic model, a difference of measurement values of an open-circuit voltage of the target secondary battery between a start time and an end time of the specified period as the characteristic parameter measurement values received by the input processing element, and a difference in the present battery capacity, and
the deterioration state estimation processing element estimates a first degree of deterioration according to an increasing function having a difference between the first initial index value and the first present index value as a main variable, or a decreasing function having a ratio of the first present index value with respect to the first initial index value as a main variable.

2. (Amended) The battery performance evaluation device according to claim 1,
wherein the initial characteristic estimation processing element receives, from the input processing element, a measurement value of a temperature of the target secondary battery as the characteristic parameter measurement value received by the input processing element at an arbitrary time in the specified period thereby to determine a first initial characteristic model parameter for defining a corresponding first initial characteristic model.

3. (Amended) The battery performance evaluation device according to claim 1 or 2,

wherein the initial characteristic estimation processing element estimates a second initial index value according to an increasing function having, as a main variable, an initial internal resistance of the target secondary battery determined as an output of a second initial characteristic model by inputting, to the second initial characteristic model, a measurement value of at least one of a voltage and a current of the target secondary battery at an arbitrary time in the specified period as the characteristic parameter measurement value received by the input processing element,
the present characteristic estimation processing element estimates a second present index value according to an increasing function having, as a main variable, a present internal resistance of the target secondary battery calculated on the basis of measurement values of an open-circuit voltage, a voltage, and a current of the target secondary battery in the specified period as the characteristic parameter measurement values received by the input processing element, and
the deterioration state estimation processing element estimates a second degree of deterioration according to a decreasing function having a difference between the second initial index value and the second present index value as a main variable, or an increasing function having a ratio of the second present index value with respect to the second initial index value as a main variable.

4. (Amended) The battery performance evaluation device according to claim 3,
wherein the initial characteristic estimation processing element receives, from the input processing element, a measurement value of a temperature of the target secondary battery at an arbitrary time in the specified period as the characteristic parameter measurement value thereby to determine a second initial characteristic model parameter for defining a corresponding second initial characteristic model.

5. (Amended) The battery performance evaluation device according to claim 3 or 4,
wherein the deterioration state estimation processing element determines a combined degree of deterioration combining the first degree of deterioration and the second degree of deterioration.

6. (Amended) The battery performance evaluation device according to claim 5,

wherein the deterioration state estimation processing element
calculates the combined degree of deterioration according to a relational expression including a first weighting coefficient C1 and a second weighting coefficient C2, and
determines the combined degree of deterioration by setting the first weighting coefficient C1 to be larger than the second weighting coefficient C2 and by increasing a difference therebetween in the case where variance in a time series of measurement values of a current of the target secondary battery in the specified period is below a threshold value, or determines the combined degree of deterioration by setting the first weighting coefficient C1 to be smaller than the second weighting coefficient C2 and by increasing a difference therebetween in the case where variance in a time series of measurement values of a current of the target secondary battery in the specified period is equal to or more than the threshold value.

7. (Deleted)

8. (Amended) A software server imparting a function as the battery performance evaluation device described in any one of claims 1 to 6 to an arithmetic processing device, which is provided in a target device with the target secondary battery installed therein, by downloading software for determining deterioration to the arithmetic processing device.

9. (Amended) A battery performance evaluation method, comprising:

an initial characteristic estimation step of estimating a first initial index value according to an increasing function having, as a main variable, a difference in initial battery capacity of a target secondary battery between a start time and an end time in a specified period, the first initial index value being determined as an output of a first initial characteristic model by inputting, to the first initial characteristic model, a measurement value of an open-circuit voltage of the target secondary battery at each of the start time and the end time of the specified period including a period during which a current flows through the target secondary battery, and a time series of measurement values of a current of the target secondary battery in the specified period;

a present characteristic estimation step of estimating a first present index value according to an increasing function having, as a main variable, a difference in present battery capacity calculated from a time integral value or a cumulative value of a current of the target secondary battery between the start time and the end time of the specified period on the basis of measurement value of the open-circuit voltage of the target secondary battery at each of the start time and the end time of the specified period, and a time series of measurement values of a current of the target secondary battery in the specified period; and

a degree of deterioration evaluation step of estimating a first degree of deterioration according to an increasing function having a difference between the first initial index value and the first present index value as a main variable, or a decreasing function having a ratio of the first initial index value with respect to the first present index value as a main variable.

The amended claim 1 incorporates some of the features of claim 7 into original claim 1, and adds a hardware configuration thereto. According to the amendment, original claim 7 has been deleted.

The amended claims 1, 3, and 9 includes the methods for estimating an initial index value, a present index value, and a degree of deterioration. These amendments are based on the description in paragraphs [0051] to [0064] of the specification.

The amended claims 2 and 4 are based on the description in paragraphs [0052] and [0059] , respectively, of the specification.

The amended claims 5 and 6 are based on the description in paragraph [0066] of the specification.

The amended claim 8 is based on the description in paragraph [0018] of the specification.

FIG.1

BATTERY PERFORMANCE EVALUATION DEVICE

100

INPUT PROCESSING ELEMENT — 102

OUTPUT PROCESSING ELEMENT — 104

INITIAL CHARACTERISTIC ESTIMATION PROCESSING ELEMENT — 110

PRESENT CHARACTERISTIC ESTIMATION PROCESSING ELEMENT — 120

DETERIORATION STATE ESTIMATION PROCESSING ELEMENT — 140

NETWORK

200

TARGET DEVICE

INPUT INTERFACE — 202

OUTPUT INTERFACE — 204

CONTROL UNIT — 210

SECONDARY BATTERY — 220

SENSOR GROUP — 230

EP 4 354 165 A1

FIG.2

EP 4 354 165 A1

# FIG.3

16

FIG.4

**TARGET DEVICE**

START

STEP210 — MEASURE VOC1

STEP212 — IS FIRST SPECIFIED CONDITION SATISFIED?
- NO → END
- YES

STEP214 — $k \leftarrow 1$

STEP216 — MEASURE V(k), I(k), AND Θ(k)

STEP218 — IS SECOND SPECIFIED CONDITION SATISFIED?
- NO → STEP219 — $k \leftarrow k+1$
- YES

STEP220 — MEASURE VOC2

STEP222 — TRANSMIT ΔVOC, V(k), I(k), AND Θ(k)

STEP224 — RECEIVE/OUTPUT I (D1, D2)

END

**BATTERY PERFORMANCE EVALUATION DEVICE**

START

STEP110 — RECEIVE ΔVOC, V(k), I(k), AND Θ(k)

STEP111 — ESTIMATE q1

STEP112 — ESTIMATE q2

STEP113 — ESTIMATE DIFFERENCE IN INITIAL BATTERY CAPACITY ΔQ (0←k)

STEP114 — ESTIMATE INITIAL INTERNAL RESISTANCE r (0←k)

STEP115 — EVALUATE FIRST INITIAL INDEX VALUE F10

STEP116 — EVALUATE SECOND INITIAL INDEX VALUE F20

STEP121 — EVALUATE DIFFERENCE IN PRESENT BATTERY CAPACITY ΔQ'

STEP122 — EVALUATE PRESENT INTERNAL RESISTANCE r

STEP123 — EVALUATE FIRST PRESENT INDEX VALUE F12

STEP124 — EVALUATE SECOND PRESENT INDEX VALUE F22

STEP141 — EVALUATE FIRST DEGREE OF DETERIORATION D1

STEP142 — EVALUATE SECOND DEGREE OF DETERIORATION D2

STEP144 — GENERATE AND TRANSMIT I(D1, D2)

END

FIG.5

# FIG.6

100%

50%

0%

DETERIORATION DEGREE OF BATTERY IS 30%.
WE RECOMMEND REPLACING
THE BATTERY IN 150 DAYS.

## INTERNATIONAL SEARCH REPORT

| International application No. |
|---|
| **PCT/JP2022/024726** |

**A. CLASSIFICATION OF SUBJECT MATTER**

*G01R 31/392*(2019.01)i; *G01R 31/367*(2019.01)i; *H01M 10/42*(2006.01)i; *H01M 10/48*(2006.01)i; *H02J 7/00*(2006.01)i
FI:   G01R31/392; G01R31/367; H01M10/48 P; H01M10/48 301; H01M10/42 P; H02J7/00 Q

According to International Patent Classification (IPC) or to both national classification and IPC

**B.   FIELDS SEARCHED**

Minimum documentation searched (classification system followed by classification symbols)

G01R31/36-31/396; H01M10/42; H01M10/48; H02J7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| X | WO 2019/187264 A1 (TOYO SYSTEM CO., LTD.) 03 October 2019 (2019-10-03) claim 8, paragraphs [0009]-[0072], fig. 1-7 | 8 |
| Y | | 3-5, 7-8 |
| X | JP 2013-53943 A (TOYOTA MOTOR CORP) 21 March 2013 (2013-03-21) paragraphs [0001], [0013]-[0058], fig. 1-7 | 1-2 |
| Y | | 3-5, 7-8 |
| A | WO 2021/020250 A1 (DENSO CORPORATION) 04 February 2021 (2021-02-04) entire text | 1-9 |
| A | JP 2021-69163 A (FURUKAWA ELECTRIC CO LTD) 30 April 2021 (2021-04-30) entire text | 1-9 |
| P, A | WO 2021/210346 A1 (TOYO SYSTEM CO., LTD.) 21 October 2021 (2021-10-21) entire text | 1-9 |
| E, A | JP 7090949 B1 (TOYO SYSTEM CO., LTD.) 27 June 2022 (2022-06-27) entire text | 1-9 |

☐ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 August 2022** | **23 August 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2022/024726**

| Patent document cited in search report | | | Publication date (day/month/year) | Patent family member(s) | | | Publication date (day/month/year) |
|---|---|---|---|---|---|---|---|
| WO | 2019/187264 | A1 | 03 October 2019 | US | 2021/0028510 | A1 | |
| | | | | claim 8, paragraphs [0018]-[0067], fig. 1-7 | | | |
| | | | | EP | 3780248 | A1 | |
| | | | | CA | 3095272 | A1 | |
| | | | | KR | 10-2020-0128170 | A | |
| | | | | CN | 111902996 | A | |
| | | | | TW | 201942590 | A | |
| | | | | JP | 6745554 | B2 | |
| | | | | JP | 2020-191778 | A | |
| | | | | JP | 2020-191779 | A | |
| | | | | JP | 2020-191780 | A | |
| | | | | JP | 2020-198780 | A | |
| JP | 2013-53943 | A | 21 March 2013 | (Family: none) | | | |
| WO | 2021/020250 | A1 | 04 February 2021 | US | 2022/0146590 | A1 | |
| | | | | EP | 4009413 | A1 | |
| | | | | CN | 114207457 | A | |
| | | | | JP | 2021-27031 | A | |
| JP | 2021-69163 | A | 30 April 2021 | (Family: none) | | | |
| WO | 2021/210346 | A1 | 21 October 2021 | EP | 3951409 | A1 | |
| | | | | CA | 3141786 | A1 | |
| | | | | KR | 10-2021-0149795 | A | |
| | | | | CN | 113826020 | A | |
| | | | | TW | 202201019 | A | |
| | | | | JP | 2021-167798 | A | |
| JP | 7090949 | B1 | 27 June 2022 | (Family: none) | | | |

Form PCT/ISA/210 (patent family annex) (January 2015)

**REFERENCES CITED IN THE DESCRIPTION**

**Patent documents cited in the description**

• JP 6745554 B